## Europäisches Patentamt
## European Patent Office
## Office européen des brevets

(11) Publication number: **0 165 855**
**B1**

# EUROPEAN PATENT SPECIFICATION

(45) Date of publication of patent specification: **22.08.90**

(51) Int. Cl.⁵: **H 03 K 17/16,** H 03 K 17/22

(21) Application number: **85401050.1**

(22) Date of filing: **29.05.85**

(54) Output control circuit for integrated circuit device preventing initial spike noise.

(30) Priority: **30.05.84 JP 108529/84**

(43) Date of publication of application:
**27.12.85 Bulletin 85/52**

(45) Publication of the grant of the patent:
**22.08.90 Bulletin 90/34**

(84) Designated Contracting States:
**DE FR GB**

(56) References cited:
**US-A-4 019 070**

**IBM TECHNICAL DISCLOSURE BULLETIN, vol. 20, no. 6, November 1977, pages 2370-2371, New York, US; C.R. HOFFMAN: "Anti-glitch circuit"**

(73) Proprietor: **FUJITSU LIMITED**
**1015, Kamikodanaka Nakahara-ku Kawasaki-shi Kanagawa 211 (JP)**

(72) Inventor: **Asami, Fumitaka**
**27-1-23-202, Fujimidai 1 chome Kunitachi-shi Tokyo 186 (JP)**

(74) Representative: **Descourtieux, Philippe et al CABINET BEAU de LOMENIE 55 rue d'Amsterdam F-75008 Paris (FR)**

Courier Press, Leamington Spa, England.

## Description

### Background to the Invention

This invention relates to an output control circuit for an IC (integrated circuit) whose output is prevented from generating a spike noise at the starting time when the source voltage is building up in the IC.

Many output circuits of IC devices, especially output circuits of CMOS (complementary metal oxide semiconductor) devices generate a click noise or spike noise at the beginning of operation, namely when the voltage source is switched on and the device starts to operate. Usually, such initial spike noise is very small and harmless since the source voltage is still not sufficiently built up and is low compared to the operation voltage of the IC. But it makes trouble if the circuit or device receiving the output of the IC comprises a sensitive circuit such as flip-flop circuit or latch circuit, which is already in an operating condition to be driven by a small pulse.

Such spike noise is generated in the inner logic circuit of the IC, at the starting of its operation. A reason for the generation of the initial spike noise is considered to lie in the interaction between the building-up phenomena of the source voltage $V_{cc}$ and of the threshold voltages $V_{th}$ for various transistors, especially in enhancement type transistors composing the logic circuit of the IC. Namely, when the voltage supply source is switched on and the gate voltage increases over the threshold voltage $V_{th}$, the transistors begin to flow their drain currents, but since the threshold voltages of the transistors are different from each other, they will begin to flow their drain current at random. So, at the start of the operation of the IC, there is an instant when the logic circuit works in a disorderly fashion, and an output pulse may be generated. The chances of such an initial spike noise being generated are therefore increased as the complexity of the IC increases.

In order to avoid malfunction in a following stage of the system caused by the initial spike noise of the IC, it has been proposed to provide a reset circuit between the IC and the following stage of the system, so as to keep the system waiting until the beginning of the normal operation of the IC stage. But such a method requires a long time until the entire system is ready to operate normally. Moreover, it requires rather complicated reset circuits in many points of the system. Therefore, the best way is to prevent the generation of the initial spike noise in each of the IC.

### Summary of the Invention

It is a general object of the invention, therefore, to provide an IC device whose initial spike noise is suppressed.

Another object of the invention is to provide an output control circuit for an IC device which prevents the generation of the initial spike noise at the output of the IC device.

Foregoing objects are obtained by inserting a control circuit between the inner circuit and the output circuit of the IC, said control circuit comprising the features specified in Claim 1.

Thus, the control circuit clamps the input voltage of the output circuit of the IC to a determined level and keeps said output circuit in reset state until the inner circuit of the IC is ready to operate normally.

The resistive element is preferably a pure resistance, but it could be a resistor or a normally on-type transistor which acts as a resistance in the control circuit.

The invention will be more readily understood from the following description of preferred embodiments, with reference to the accompanying drawings.

### Brief Description of the Drawings

Fig. 1 is a graph illustrating how the initial spike noise is generated at the output of an IC.

Fig. 2(a) and Fig. 2(b) show a circuit diagram of an embodiment of the output control circuit according to the present invention, applied respectively to an open drain type output buffer circuit, and to a push-pull type output buffer circuit.

Fig. 3 shows another embodiment of the output control circuit according to the present invention applied to a push-pull type output buffer circuit.

### Detailed Description of the Preferred Embodiments

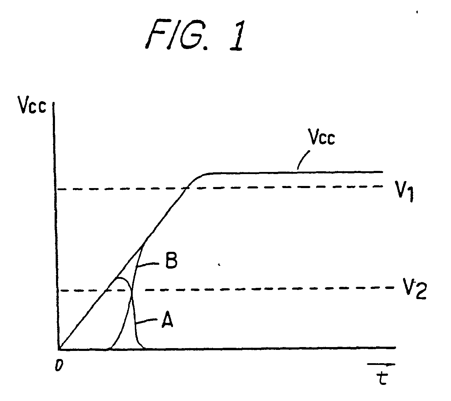

First, the manner in which the initial spike noise is generated, will be described briefly. Fig. 1 is a graph showing the transient situation of the voltage build-up in a FET (field effect transistor) when the supply voltage $V_{cc}$ is switched on. Abscissa shows time t taken from the instance of switching on. Ordinate is the voltage $V_{cc}$ appearing on the voltage supply line, or source voltage of the FET operated by voltage $V_{cc}$.

The source voltage builds up from the instance of switching on (t=0), as shown by the curve $V_{cc}$, and becomes a designed voltage, 5 volts for example. A broken line $V_1$ indicates the voltage for which the normal operation of the circuit is guaranteed, 4.5 volts for example, and a broken line V2 indicates the lowest voltage for which the circuit begins to operate, 1.5 volts for example. These voltages $V_1$ and $V_2$ depend on the circuit design and circuit elements used in the circuit. The time duration of the transient phenomenon is of 2 ms for instance, and of course, it depends also on the circuit.

Curve A in Fig. 1 shows the behaviour of an enhancement type FET whose initial state should be low state L (or ON state). Considering an n-channel FET, in order to keep its output voltage at low level, the gate voltage should be at high level H. But if the foregoing stage of the FET is still not operated properly, and the gate voltage is insufficient, the output voltage will increase as the $V_{cc}$ goes up. And when the voltage $V_{cc}$ reaches the lowest voltage $V_2$ at which the circuit works properly, the FET is switched ON and the output voltage will go down as shown by the curve A. As can be seen in the figure, the FET generates an initial spike noise.

Curve B in Fig. 1 shows the behaviour of a FET whose initial state should be H level (or OFF state). In this case, a p-channel FET is considered. In order to keep its output voltage at H level, the gate voltage should be at H level; therefore, under the same conditions as in the above case, the output voltage will go up after some delay, as shown by the curve B. If this output signal is differentiated, it will produce a pulse.

As already mentioned, as the logic circuit becomes complicated, the chances of such an initial spike pulse being generated are increased. The present invention intends to suppress such spike noise by incorporating an output control circuit in the IC. It should be pointed out that it is important to make the output control circuit operate perfectly, even during the transient condition when the supply voltage is beginning to build-up.

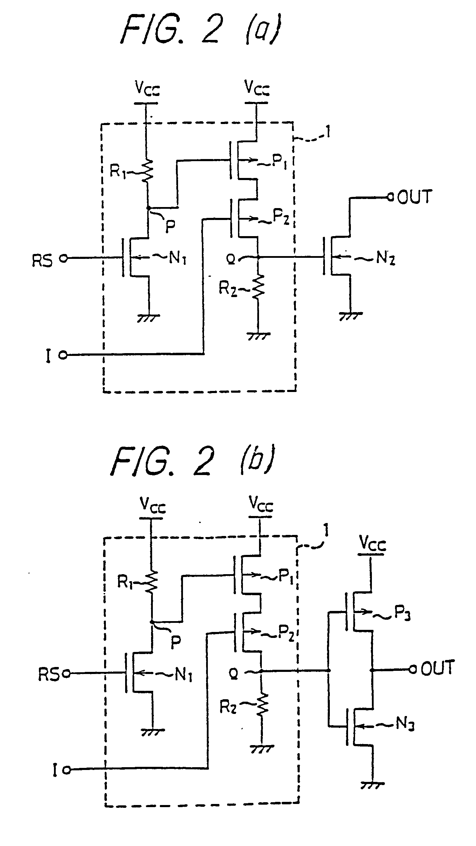

Figs. 2(a) and 2(b) show a circuit diagram of an embodiment of the present invention respectively applied to an open drain type output buffer circuit, and to a push-pull type output buffer circuit. In these figures, the output control circuit of the invention is enclosed by a broken line 1. The circuit is composed of two stages. The first stage comprises a resistor $R_1$ and a first FET $N_1$ of the n-channel type connected in series between a first voltage source line, i.e. the positive side of a voltage supply source $V_{cc}$, and a second voltage source, i.e. the negative side of the voltage supply source, in this case the latter being the ground line (GND). The second stage comprises a second FET $P_1$ of the p-channel type, a third FET $P_2$ of the p-channel type and a second resistor $R_2$. They are connected in series between the first and the second voltage supply lines ($V_{cc}$ and ground).

In Fig. 2 (a), the gate of the first FET $N_1$ is connected to a terminal RS which receives a reset signal. The connection point P of the drain of the first FET $N_1$ and of one end of the first resistor $R_1$ is connected to the gate of the second FET $P_1$. To the gate of the third FET $P_2$ is fed an input signal I, that is the output signal of the inner logic circuit of the IC (not shown). The drain of the second FET $P_1$ and the source of the third FET $P_2$ are connected to each other, and the connection point Q of the drain of the third FET $P_2$ and of one end of the second resistor $R_2$ is connected to the gate of an n-channel output gate transistor $N_2$. The source of the output transistor $N_2$ is connected to the second source line (ground), and its drain is connected to an output terminal OUT. Thus, the output circuit is an open drain circuit.

The operation of the above described circuit is characterized in that when the IC is switched on and the source voltage is applied, a reset signal is applied to the reset terminal RS and the output gate is clamped to a reset condition until the supply voltage builds up to a steady state. When the source voltage has built up, the reset signal is released and the output gate is operated normally.

The operation of the circuit of Fig. 2(a) is as follows. At the starting time, that is at the time when the supply voltage for the IC is switched on, a reset signal of low level (L) is applied to the reset terminal RS. The reset signal may be applied before the supply voltage is switched on. By this reset signal, the first FET $N_1$ is cut off and, the circuit point P is charged up to the source voltage V through the first resistor $R_1$. The gate of the p-channel second FET $P_1$ is then at high level (H). It should be pointed out that the high level (H), in this case, is not identical to that of the logic circuit when the voltage $V_{cc}$ is in its normal state. Since, in this case, the voltage $V_{cc}$ is still in building up phase, its value is lower than in normal condition. Nevertheless, the gate voltage appearing at the gate of the FET $P_1$ is at high level for each instant of the voltage building up. Accordingly, the second FET $P_1$ is also cut off.

Under such conditions, regardless of whether H or L level appears at the input terminal I, current does not flow through the second resistor $R_2$, since the second FET $P_1$ is cut off. Therefore, the gate of the output transistor $N_2$ is clamped to earth potential through the second resistor $R_2$, and the initial spike noise is suppressed. The reference character I will be used hereinafter to designate either the input signal or input terminal.

When the source voltage reaches its normal value, the reset terminal RS is switched to H level. By this switching, the first FET $N_1$ is turned to the ON state, and the level at the circuit point P, hence at the gate of the second FET $P_1$ becomes low (L), so the second FET $P_1$ becomes conductive (ON state). Therefore, the third FET $P_2$ is supplied with the $V_{cc}$ voltage through the first FET $P_1$ and begins its switching action. Namely, according as the level of the input signal appearing at the input terminal I is H or L, the level at the circuit point Q varies to L or H, and the output transistor $N_2$ is driven.

In order to secure the above operation even during the transient phase of the supply voltage building up, it is preferably that the circuit elements $R_1$ and $R_2$ be purely resistive though their resistance values are not so critical. If not, the voltage at the circuit points P and Q will not follow the variation of $V_{cc}$ in time, and if there is a phase or time difference between them, the circuit does not work well.

In the above embodiment and the following description of the invention, the circuit elements $R_1$ and $R_2$ are considered as resistors. But it will be clear for the ones skilled in the art that the circuit elements $R_1$ and $R_2$ are not restricted to be resistors; they may be, for example, a normally on type FET. In fact, from the view point of circuit manufacturing, it is favourable to replace the resistors with proper FETs, because they can be fabricated with the same process as the other FETs included in the IC, and there is no need to add a process step for fabricating resistors. It should be pointed out that the FETs used as the resistive elements should be of normally on type because, if conventional FETs are provided, they will not work well until the source voltage reaches its lowest operating value ($V_2$).

The value of resistances $R_1$ and $R_2$ are not critical; they may be chosen in a range from a few hundreds of ohms to a few hundreds of kilo ohms. If the resistances become too small, the current running through the resistors becomes large and the circuit loss increases; on the contrary, if the resistances become too high, the time constant of the circuit becomes large and the operation cannot follow the voltage building up of $V_{cc}$. When the resistors are replaced by normally on type FETs, it is well known that the effective inner resistance of a FET is determined by the width and length of the channel, so that the size of the FET may be designed by anyone skilled in the art to obtain the desired resistance values. Usually, it is unnecessary to design a special pattern FET, because, in ordinary ICs, there are many FET patterns used for the inner logic circuit, so that a proper one may be found to be used for the resistive element.

Fig. 2(b) shows an embodiment of the invention which is applied to a push-pull type output circuit. The output control circuit encircled with a broken line 1 is identical to that of Fig. 2(a). In this case the circuit point Q is connected to the commonly connected gates of push-pull type output transistors $P_3$(p-channel) and $N_3$ (n-channel). As described before, the gate of the output circuit is clamped to the earth potential until the reset signal applied to the terminal RS is released (changed from L to H).

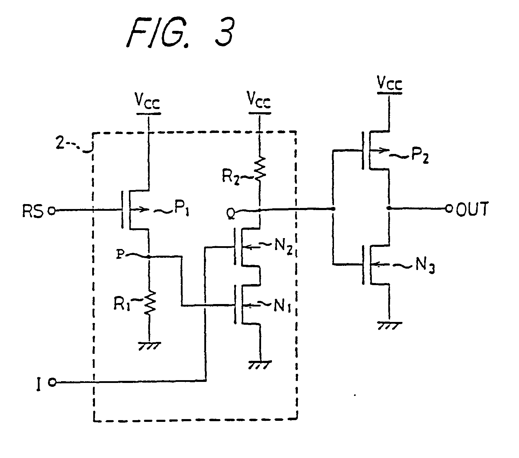

In the above explanation, the reset signal applied to the reset terminal is kept to low level L until the circuit voltage builds up properly. These reset signal is applied from an outer circuit to the IC. Therefore, there may be a case where the level of the reset signal is reversed, namely the reset signal is H during the starting phase, and then varies to L. An embodiment of a circuit usable in such a case is shown in Fig. 3.

In Fig. 3, the output control circuit according to the invention is shown encircled with a broken line 2. The figure shows a case in which the circuit is applied to a push-pull type output buffer circuit. Like reference symbols or numerals refer to like or similar elements of Fig. 2(b). The circuit is composed of two stages. The first stage comprises a first FET $P_1$ of p-channel type and a first resistive element $R_1$. They are connected in series between the first voltage supply line ($V_{cc}$) and the second voltage supply line which, in this case is the ground. The second stage comprises a second FET $N_1$ of n-channel type, a third FET $N_2$ of n-channel type and a second resistive element $R_2$ connected in series between the second voltage supply line and the first voltage supply line.

The gate of the first FET $P_1$ is connected to the reset signal terminal RS, and the circuit point P which is the connection point of the drain of $P_1$ with one end of $R_1$ is connected to the gate of the second FET $N_1$. The drain of $N_1$ and the source of $N_2$ are connected to each other, and the input terminal I, which is the output terminal of an inner logic circuit (not shown) is connected to the gate of the third FET $N_2$. The junction point Q which connects one end of $R_2$ to the drain of $N_2$ is connected to the commonly connected gates of output transistors $P_2$ (p-channel) and $N_3$ (n-channel).

The operation of the circuit of Fig. 3 is similar to that of Fig. 2(b), except for the reset signal. In the circuit of Fig. 3, a reset signal of H level is applied to the reset terminal RS at the starting time of the operation of the IC. The reset signal may be applied in advance of the start. Then the first FET $P_1$ is cut off and the channel point P is grounded through the first resistive element $R_1$. Therefore, the second FET $N_1$ is cut off and the circuit point Q is charged up to H level through the resistor $R_2$. Thus, the gates of the output transistors $P_2$ and $N_3$ are clamped to H level whether the level of the input signal is H or L. The output is then kept to the L level until the reset signal is released. When the voltage of the supply line reaches a steady state, the reset signal varies from H to L, then $P_1$ is cut off and the circuit point P reaches the level L, so the FET $N_1$ becomes conductive. Thus, the input signal is transferred to the circuit point Q by the third FET $N_2$, and the IC begins to operate.

In Fig. 3, an embodiment applied to a push-pull type output circuit is shown. But it will be easy for anyone skilled in the art to apply it to any other type of output circuit. Further modifications may be made to the above described circuits without departing from the scope of the invention as defined by the claims. For example, the input of the output circuit may be clamped to the source voltage rather than to the earth potential.

## Claims

1. An output control circuit (1, 2) for preventing the transmission of an initial noise spike which may be output by an electronic circuit at the starting time when the supply voltage of said electronic circuit is building up, comprising an input terminal (I) to be connected to the output of said electronic circuit, an output terminal, first and second voltage supply lines for ($V_{cc}$, GROUND) for providing said supply voltage, a first transistor ($N_1$, Figures 2a and 2b; $P_1$, Figure 3) connected between a first junction point (P) and said second supply line for providing a turning off signal to a second transistor ($P_1$, Figures 2a and 2b; $N_1$, Figure 3) connected in series with a third transistor ($P_2$, Figures 2a and 2b; $N_2$, Figure 3) between said first supply line and a second junction point (Q) operatively connected to said output terminal, said third transistor having a gate connected to said input terminal (I), characterized in that it comprises a first resistive element ($R_1$) having a first end connected to said first voltage supply line and a second end connected to the first junction point (P); that said first transistor ($N_1$, Figures 2a and 2b; $P_1$, Figure 3) has a gate connected to a reset terminal (RS) for receiving a reset signal provided by an outer circuit to said electronic circuit at the starting time, possibly in advance of the start, said first transistor being turned off in response to said reset signal; that said second transistor ($P_1$, Figures 2a and 2b; $N_1$, Figure 3) has a gate connected to said first junction point (P) such that said second transistor is turned off when the reset signal is applied to the gate of said first transistor; and that a second resistive element ($R_2$) is connected between said second junction point (Q) and said second voltage supply line.

2. An output control circuit according to claim 1, wherein (Figures 2a, 2b):

said first voltage supply line supplies a higher voltage than said second voltage supply line;

said first transistor ($N_1$) is a first n-channel FET having a source connected to said second voltage supply line, a drain connected to said first junction point (P);

said second transistor ($P_1$) is a first p-channel FET having a source connected to the first voltage supply line, a gate connected to said first junction point (P), and a drain;

said third transistor ($P_2$) is a second p-channel FET having a source connected to the drain of said first p-channel FET, and a drain connected to said second junction point (Q).

3. An output control circuit according to claim 1, wherein (Figure 3):

said second voltage supply line supplies a higher voltage than said first voltage supply line;

said first transistor ($P_1$) is a first p-channel FET having a source connected to said second voltage supply line, and a drain connected to said first junction point (P);

said second transistor ($N_1$) is a first n-channel FET having a source connected to said first voltage supply line, and a drain; and

said third transistor ($N_2$) is a second n-channel FET having a source connected to the drain of said first n-channel FET, and a drain connected to said second junction point (Q).

4. An output control circuit according to any one of claims 1 to 3, wherein the resistance of said first and second resistive elements ($R_1$, $R_2$) is in a range from a few hundreds ohms to a few hundred kilo ohms.

5. An output control circuit according to claim 4, wherein at least one of said first and second resistive elements ($R_1$, $R_2$) is a resistor having a resistance in a range from a few hundred ohms to a few hundred kilo ohms.

6. An output control circuit according to claim 4, wherein at least one of said first and second resistive elements ($R_1$, $R_2$) is normally on type FET having an effective inner resistance in a range from a few hundred ohms to a few hundred kilo ohms.

7. An output control circuit according to claim 2, wherein the reset signal is at a low level while the supply voltage is rising, and it changes to a high level when the supply voltage reaches a predetermined voltage level.

8. An output control circuit according to claim 3, wherein the reset signal is at a high level while the supply voltage is rising, and changes to low level when the supply voltage reaches a specified voltage.

9. An output control circuit according to any one of claims 1 to 8, wherein said electronic circuit is an integrated circuit (IC) device, the first voltage supply line is the positive side of the voltage source of the IC, and the second voltage supply line is the negative side of the voltage source of the IC.

**Patentansprüche**

1. Ausgangssteuerschaltung (1, 2) zur Verhinderung der Transmission eines anfänglichen Rauschnadelimpulses, der durch eine elektronische Schaltung zur Startzeit ausgegeben werden kann, wenn die Versorgungsspannung der genannten elektronischen Schaltung sich aufbaut, mit einem Eingangsanschluß (I), der mit dem Ausgang der genannten elektronischen Schaltung verbunden werden soll, einem Ausgangsanschluß, einer ersten und einer zweiten Spannungsversorgungsleitung ($V_{cc}$, Erde), um die genannte Versorgungsspannung zu liefern, einem ersten Transistor ($N_1$, Figuren 2a und 2b; $P_1$, Figur 3), der zwischen einem ersten Koppelpunkt (P) und der genannten zweiten Versorgungsleitung angeschlossen ist, um ein Abschaltsignal an einen zweiten Transistor ($P_1$, Figuren 2a und 2b; $N_1$, Figur 3) zu liefern, der in Reihe mit einem dritten Transistor ($P_2$, Figuren 2a und 2b; $N_2$, Figur 3) zwischen der genannten ersten Versorgungsleitung und einem zweiten Koppelpunkt (Q) verbunden ist, der wirkungsmäßig mit dem genannten Ausgangsanschluß verbunden ist, wobei der genannte dritte Transistor ein Gate hat, das mit dem genannten Eingangsanschluß (I) verbunden ist, dadurch gekennzeichnet, daß sie ein erstes Widerstandselement ($R_1$) umfaßt, das ein erstes, mit der genannten ersten Spannungsversorgungsleitung verbundenes Ende und ein zweites, mit dem genannten ersten Koppelpunkt (P) verbundenes Ende hat; daß der genannte erste Transistor ($N_1$, Figuren 2a und 2b; $P_1$, Figur 3) ein Gate hat, das mit einem Rücksetzanschluß (RS) verbunden ist, um ein Rücksetzsignal zu empfangen, das zur Startzeit, möglicher Weise vor dem Start, von einer äußeren Schaltung an die genannte elektronische Schaltung geliefert wird, wobei der genannte erste Transistor in Abhängikeit von dem genannten Rücksetzsignal ausgeschaltet wird; daß der genannte zweite Transistor ($P_1$, Figuren 2a und 2b; $N_1$, Figur 3) ein Gate hat, das mit dem genannten ersten Koppelpunkt (P) so verbunden ist, daß der genannte zweite Transistor ausgeschaltet wird, wenn das Rücksetzsignal dem Gate des genannten ersten Transistors zugeführt wird; und daß ein zweites Widerstandselement ($R_2$) zwischen dem genannten zweiten Koppelpunkt (Q) und der genannten zweiten Spannungsversorgungsleitung verbunden ist.

2. Ausgangssteuerschaltung nach Anspruch 1, bei der (Figuren 2a, 2b):

die genannte erste Spannungsversorgungsleitung eine höhere Spannung als die genannte zweite Spannungsversorgungsleitung liefert;

der genannte erste Transistor (N$_1$) ein erster n-Kanal-FET ist, der eine Source hat, die mit der genannten zweiten Spannungsversorgungsleitung verbunden ist, und ein Drain, das mit dem genannten ersten Koppelpunkt (P) verbunden ist;

der genannte zweite Transistor (P$_1$) ein erster p-Kanal-FET ist, der eine Source, die mit der ersten Spannungsversorgungsleitung verbunden ist, ein Gate, das mit dem genannten Koppelpunkt (P) verbunden ist, und ein Drain hat;

der genannte dritte Transistor (P$_2$) ein zweiter p-Kanal-FET ist, der eine Source hat, die mit dem Drain des genannten ersten p-Kanal-FET verbunden ist, und ein Drain, das mit dem genannten zweiten Koppelpunkt (Q) verbunden ist.

3. Ausgangssteuerschaltung nach Anspruch 1, bei der (Figur 3).

die genannte zweite Spannungsversorgungsleitung eine höhere Spannung als die erste Spannungsversorgungsleitung liefert;

der genannte erste Transistor (P$_1$) ein erster p-Kanal-FET ist, der eine Source hat, die mit der genannten zweiten Spannungsversorgungsleitung verbunden ist, und ein Drain, das mit dem genannten ersten Koppelpunkt (P) verbunden is;

der genannte zweite Transistor (N$_1$) ein erster n-Kanal-FET ist, der eine Source, die mit der genannten ersten Spannungsversorgungsleitung verbunden ist, und ein Drain hat; und

der genannte dritte Transistor (N$_2$) ein zweiter n-Kanal-FET ist, der eine Source hat, die mit dem Drain des genannten ersten n-Kanal-FET verbunden ist, und ein Drain, das mit dem genannten zweiten Koppelpunkt (Q) verbunden ist.

4. Ausgangssteuerschaltung nach einem der Ansprüche 1 bis 3, bei der der Widerstand der genannten ersten und zweiten Widerstandselemente (R$_1$, R$_2$) im Bereich von wenigen hundert Ohm bis zu wenigen hundert kilo Ohm liegt.

5. Ausgangssteuerschaltung nach Anspruch 4, bei der wenigstens eines der genannten ersten und zweiten Widerstandselemente (R$_1$ R$_2$) ein Widerstand ist, der einen Wert im Bereich von einigen hundert Ohm bis einigen hundert kilo Ohm hat.

6. Ausgangssteuerschaltung nach Anspruch 4, bei der wenigstens eines der genannten ersten und zweiten Widerstandselemente (R$_1$, R$_2$) normalerweise eingeschalteter FET ist, der einen effektiven inneren Widerstand im Bereich von einigen hundert Ohm bis zu einigen hundert kilo Ohm hat.

7. Ausgangssteuerschaltung nach Anspruch 2, bei der das Rücksetzsignal auf einem niedrigen Pegel ist, während die Versorgungsspannung ansteigt, und zu einem hohen Pegel wechselt, wenn die Versorgungsspannung einen vorhestimmten Spannungspegel erreicht.

8. Ausgangssteuerschaltung nach Anspruch 3, bei der das Rücksetzsignal auf einem hohen Pegel ist, während die Versorgungsspannung ansteigt, und zu einenn niedrigen Pegel wbchsel, wenn die Versorgungsspannung eine spezifizierte Spannung erreicht.

9. Ausgangssteuerschaltung nach einem der Ansprüche 1 bis 8, bei der die genannte elektronsche Schaltung eine integrierte Schaltungsvorrichtung (IC) ist, die erste Spannungsversorgungsleitung die positive Seite der Spannungsquelle der IC ist, und die zweite Spannungsversorgungsleitung die negative Seite der Spannungsquelle der IC ist.

**Revendications**

1. Circuit de commande de sortie (1, 2) destiné à empêcher la transmission d'un bruit de pointe initial qui peut être fourni par un circuit électronique au moment du démarrage, lorsque la tension d'alimentation dudit circuit électronique est en train de s'établir, comprenant une borne d'entrée (I) devant être connectée à la sortie dudit circuit électronique, une borne de sortie, des première et deuxième lignes d'alimentation en tension (V$_{cc}$, terre) servant à produire ladite tension d'alimentation, un premier transistor (N$_1$, figures 2a et 2b; P$_1$, figure 3) connecté entre un premier point de jonction (P) et ladite deuxième ligne d'alimentation et servant à fournir un signal de passage dans l'état non conducteur à un deuxième transistor (P$_1$, figure 2a et 2b; N$_1$, figure 3) connecté en série avec un troisième transistor (P$_2$, figure 2a et 2b; N$_2$, figure 3) entre ladite première ligne d'alimentation et un deuxième point de jonction (Q) fonctionnellement connecté à ladite borne de sortie, ledit troisième transistor ayant une grille connectée à ladite borne d'entrée (I), caractérisé en ce qu'il comprend un premier élément résistif (R$_1$) dont une première extrémité est connectée à ladite première ligne d'alimentation en tension et une deuxième extrémité est connectée au premier point de jonction (P); en ce que ledit premier transistor (N$_1$, figures 2a et 2b; P$_1$, figure 3) possède une grille connectée à une borne de repositionnement (RS) servant à recevoir un signal de repositionnement fourni par un circuit externe audit circuit électronique au moment du démarrage, éventuellement avant le démarrage, ledit premier transistor étant rendu non conducteur en réponse audit signal de repositionnement; en ce que ledit deuxième transistor (P$_1$, figures 2a et 2b; N$_1$, figure 3) possède une grille connectée audit premier point de jonction (P) de sorte que ledit deuxième transistor est rendu non conducteur lorsque le signal de repositionnement est appliqué à la grille dudit premier transistor; et en ce qu'un deuxième élément résistif (R$_2$) est connecté entre ledit deuxième point de jonction (Q) et ladite deuxième ligne d'alimentation en tension.

2. Circuit de commande de sortie selon la revendication 1, où (figures 2a, 2b):

ladite première ligne d'alimentation en tension fournit une tension plus élevée que ladite deuxième ligne d'alimentation en tension;

ledit premier transistor (N$_1$) est un premier FET à canal n possédant une source connectée à ladite deuxième ligne d'alimentation en tension, et un drain connecté audit premier point de jonction (P);

ledit deuxième transistor (P₁) est un premier FET à canal p possédant une source connectée à la première ligne d'alimentation en tension, une grille connectée audit premier point de jonction (P), et un drain;

ledit troisième transistor (P₂) est un deuxième FET à canal p possédant une source connectée au drain dudit premier FET à canal p, et un drain connecté audit deuxième point de jonction (Q).

3. Circuit de commande de sortie selon la revendication 1, où (figure 3):

ladite deuxième ligne d'alimentation en tension fournit une tension plus grande que ladite première ligne d'alimentation en tension;

ledit premier transistor (P₁) est un premier FET à canal p possédant une source connectée à ladite deuxième ligne d'alimentation en tension, et un drain connecté audit premier point de jonction (P);

ledit deuxième transistor (N₁) est un premier FET à canal n possédant une source connectée à ladite première ligne d'alimentation en tension, et un drain; et

ledit troisième transistor (N₂) est un deuxième FET à canal n possédant une source connectée au drain dudit premier FET à canal n, et un drain connecté audit deuxième point de jonction (Q).

4. Circuit de commande de sortie selon l'une quelconque des revendications 1 à 3, où la valeur de résistance desdits premier et deuxième éléments résistifs (R₁, R₂) se trouve dans un intervalle qui va de quelques centaines d'ohms à quelques centaines de kilo-ohms.

5. Circuit de commande de sortie selon la revendication 4, où au moins un desdits premier et deuxième éléments résistifs (R₁, R₂) est une résistance ayant une valeur dans un intervalle qui va de quelques centaines d'ohms à quelques centaines de kilo-ohms.

6. Circuit de commande de sortie selon la revendication 4, où au moins l'un desdits premier et deuxième éléments résistifs (R₁, R₂) est un FET du type normalement conducteur possédant une valeur de résistance interne effective comprise dans un intervalle qui va de quelques centaines d'ohms à quelques centaines de kilo-ohms.

7. Circuit de commande de sortie selon la revendication 2, où le signal de repositionnement se trouve à un niveau bas pendant que la tension d'alimentation s'élève, et passe à un niveau haut lorsque la tension d'alimentation a atteint un niveau de tension prédéterminé.

8. Circuit de commande de sortie selon la revendication 3, où le signal de repositionnement est à un niveau haut pendant que la tension d'alimentation s'élève, et passe à un niveau bas lorsque la tension d'alimentation a atteint une valeur spécifiée.

9. Circuit de commande de sortie selon l'une quelconque des revendications 1 à 8, où ledit circuit électronique est un dispositif à circuit intégré, la première ligne d'alimentation en tension est le côté positif de la source de tension du circuit intégré, et la deuxième ligne d'alimentation en tension est le côté négatif de la source de tension du circuit intégré.

EP 0 165 855 B1

# FIG. 1

## FIG. 2 (a)

## FIG. 2 (b)

# FIG. 3